# EUROPÄISCHE PATENTANMELDUNG

(11) **EP 3 057 129 A1**
(43) Veröffentlichungstag der Anmeldung: **17.08.2016**
(21) Anmeldenummer: 16000047.7
(22) Anmeldetag: 12.01.2016
(51) Int. Cl.: H01L 23/495, H01L 23/498, H01L 21/56

(54) **IC-GEHÄUSE**

(30) Priorität: 12.01.2015 DE 102015000063
(71) Anmelder: Micronas GmbH, 79108 Freiburg (DE)
(72) Erfinder: Heberle, Klaus, 79312 Emmendingen (DE); Franke, Jörg, 79117 Freiburg (DE); Leneke, Thomas, 79108 Freiburg (DE)
(74) Vertreter: Koch Müller Patentanwaltsgesellschaft mbH

(57) **Zusammenfassung**

IC-Gehäuse mit einem Halbleiterkörper, wobei der Halbleiterkörper eine monolithisch integrierte Schaltung und wenigstens zwei metallische Kontaktflächen aufweist und die integrierte Schaltung mittels Leiterbahnen mit den beiden elektrischen Kontaktflächen verschaltet ist und der Halbleiterkörper auf einem Trägersubstrat angeordnet und mit dem Trägersubstrat kraftschlüssig verbunden ist und das Trägersubstrat wenigstens zwei Anschlusskontakte aufweist und die beiden Anschlusskontakte mit den beiden Kontaktflächen verschaltet sind und der Halbleiterkörper und das Trägersubstrat mit einer Vergussmasse bedeckt sind, wobei die Vergussmasse einen Teil des IC Gehäuse ausbildet und jeweils ein Abschnitt der beiden Anschlusskontakte das IC Gehäuse durchdringt, wobei die beiden Anschlusskontakte auf dem Trägersubstrat angeordnet sind und jeder Anschlusskontakte und das unterhalb des jeweiligen Anschlusskontakte liegende Trägersubstrat eine lochartige Ausformung aufweisen, wobei die jeweilige lochartige Ausformung als Durchkontaktierung ausgebildet ist, um eine elektrische Verbindung mit einem weiteren elektrischen Bauteil bereitzustellen.

## Beschreibung

### Die Erfindung betrifft ein IC-Gehäuse

Aus der DE 10 2007 032 142 A1 ist ein Elektronikmodul bekannt. Aus Andreas Veigel et al, "Einpresstechnik - Entwicklung, Anwendung, Qualifizierung, 1.Auflage, Eugen G. Leuze Verlag, Bad Saulgau 2009, ISBN 978-3-87480-252-9, ist eine Kontaktiervorrichtung bekannt.

Vor diesem Hintergrund besteht die Aufgabe der Erfindung darin, eine Vorrichtung anzugeben, die den Stand der Technik weiterbildet.

Die Aufgabe wird durch ein IC-Gehäuse mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein IC-Gehäuse mit einem Halbleiterkörper bereitgestellt, wobei der Halbleiterkörper eine monolithisch integrierte Schaltung und wenigstens zwei metallische Kontaktflächen aufweist und die integrierte Schaltung mittels Leiterbahnen mit den beiden elektrischen Kontaktflächen verschaltet ist und der Halbleiterkörper auf einem Trägersubstrat angeordnet und mit dem Trägersubstrat kraftschlüssig verbunden ist und das Trägersubstrat wenigstens zwei Anschlusskontakte aufweist und die beiden Anschlusskontakte mit den beiden Kontaktflächen verschaltet sind und der Halbleiterkörper und das Trägersubstrat mit einer Vergussmasse bedeckt sind, wobei die Vergussmasse einen Teil des IC Gehäuses ausbildet und jeweils ein Abschnitt der beiden Anschlusskontakte die Vergussmasse des IC Gehäuses durchdringen, wobei die beiden Anschlusskontakte auf dem Trägersubstrat angeordnet sind und jeder Anschlusskontakt mit dem unterhalb des jeweiligen Anschlusskontakts liegenden Trägersubstrat eine lochartige Ausformung ausbilden, wobei die jeweilige lochartige Ausformung als Durchkontaktierung ausgebildet ist, um eine elektrische Verbindung mit einem weiteren elektrischen Bauteil bereitzustellen.

Es sei angemerkt, dass unter dem Begriff lochartig Ausformung eine durchgehende Öffnung in dem Trägersubstrat bezeichnet ist und die Wände in der Öffnung metallisch leitfähig sind, um hierdurch eine elektrisch leitende Durchkontaktierung auszubilden. Insbesondere ist die Durchkontaktierung hülsenartig ausgebildet.

Es versteht sich, dass es bevorzugt ist, das IC-Gehäuse aus der Vergussmasse und dem Trägersubstrat auszubilden. Alternativ ist auch bevorzugt, das Gehäuse ausschließlich mittels der Vergussmasse auszubilden, anders ausgedrückt die innenliegende Bauteile vollständig mit der Vergussmasse zu umschließen.

Es versteht sich, dass die Tragfähigkeit des Trägersubstrats ausreichend ist, um die Anschlusskontakte und die Durchkontaktierungen aufzunehmen, bevor mittels der Vergussmasse das IC-Gehäuse ausgebildet wird. Es sei angemerkt, dass für das Trägersubstrat auch die Bezeichnung "Lead-frame" gebräuchlich ist, nämlich insbesondere dann, wenn das Trägersubstrat aus einem Metall bzw. aus mehreren Metallstreifen besteht.

Ein Vorteil der erfindungsgemäßen Vorrichtung ist es, dass das IC-Gehäuse unmittelbar mit einem weiteren Bauteil mittels einer unmittelbar mit dem IC-Gehäuse ausgebildeten Durchkontaktierung elektrisch verschalten lässt. Eine Montage des IC-Gehäuses auf einer Trägerplatine, wobei die Trägerplatine die Durchkontaktierungen enthält, entfällt. Anders ausgedrückt lässt sich mit der erfindungsgemäßen Vorrichtung eine Verbindungsebene einsparen, indem in die Durchkontaktierungen des IC-Gehäuses vorzugsweise mittels eines Einpressstiftes mit einem übergeordneten System wie beispielsweise einem Stecker oder Kabel unmittelbar verbinden lässt. Hierdurch lässt sich die Ausbeute erhöhen und die Fügungskosten reduzieren.

In einer Weiterbildung umfasst oder besteht das Trägersubstrat aus einem elektrisch isolierenden Material. Bevorzugt sind als Material das Trägersubstrat Kunststoffverbindungen oder Metall-Kunststoffverbindungen, beispielsweise in Form von Spritzgussteilen sogenannten "molded interconnect devices". Hierbei sind die Anschlusskontakte als metallische Streifen auf dem Trägersubstrat ausgebildet.

Bei einer alternativen metallischen Ausführung des Trägersubstrats erübrigt sich eine Ausbildung von metallischen Streifen auf der Oberfläche des Trägersubstrats, in dem bereits die Anschlusskontakte selbst aus einzelnen metallischen, jedoch zueinander isolierten Streifen ausgebildet sind.

Es ist bevorzugt, dass die Durchkontaktierungen einen vorzugsweise kreisförmigen Querschnitt aufweisen. Bevorzugst ist, dass das Aspekt Verhältnis zwischen der Länge und dem Durchmesser der Durchkontaktierung mindestens größer gleich 1 ist.

In die Durchkontaktierungen lassen sich sowohl Stifte einpressen als auch Stifte verlöten. Untersuchungen haben gezeigt, dass es vorteilhaft ist, in den Durchkontaktierungen an der Lochinnenseite eine metallische Oberfläche auszubilden, wobei die metallische Oberfläche als ein Teil des Außenkontakts ausgebildet ist und vorzugsweise einstückig mit dem Außenkontakt verbunden ist. In einer alternativen Ausführungsform

Bevorzugt ist es des Weiteren die Durchkontaktierungen kraft- und stoffschlüssig mit dem Trägersubstrat zu verbinden. Hierdurch lassen sich besonders haltbare und niederohmige elektrische Verbindungen schaffen.

In einer Ausführungsform sind die Kontaktflächen mit einem Leitkleber oder mit einem Bonddraht oder mittels einer Lötverbindung oder mittels Sintern oder mittels eines Thermokompressionsbonds mit den Anschlusskontakten elektrisch verschaltet.

Auch ist es bevorzugt auf dem Trägersubstrat ein weiteres von dem Halbleiterkörper beabstandetes elektronisches Bauelement anzuordnen und beide Bauteile in einem Verfahrensschritt mit derselben Vergussmasse zu bedecken. Ein Beispiels für die beiden Bauelemente sind Hallsensoren welche entweder lateral oder stapeiförmig innerhalb des IC-Gehäuses angeordnet sind. In einer bevorzugten Weiterbildung ist das Trägersubstrat als eine plane Platte ausgebildet. In einer alternativen Ausführungsform weist das Trägersubstrat an einer Oberseite eine wannenförmige Ausformung auf, wobei der der Halbleiterkörper in einem Bodenbereich der wannenförmigen Ausformung angeordnet ist.

Vorzugsweise sind alle Durchkontaktierungen in einem Randbereich des Trägersubstrats ausgebildet. In einer alternativen Ausführungsform sind sowohl auf als auch unter dem Trägersubstrat ein oder mehrere Halbleiterkörper und / oder ein oder mehrere elektronische Bauteile angeordnet. Hierdurch lassen sich auf einfache und kostengünstige Weise Multichip-Lösungen herstellen ohne dass eine Trägerplatine benötigt wird.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine Querschnittsansicht auf eine erste erfindungsgemäße Ausführungsform eines IC-Gehäuses,
- Figur 2: eine Querschnittsansicht auf eine zweite erfindungsgemäße Ausführungsform eines IC-Gehäuses,
- Figur 3: eine Querschnittsansicht auf eine dritte erfindungsgemäße Ausführungsform eines IC-Gehäuses,
- Figur 4: eine Querschnittsansicht auf eine vierte erfindungsgemäße Ausführungsform eines IC-Gehäuses,
- Figur 5a: eine Querschnittsansicht auf eine fünfte erfindungsgemä-ße Ausführungsform eines IC-Gehäuses,
- Figur 5b: eine Draufsicht entlang der Linie A-A' der fünften erfin-dungsgemäßen Ausführungsform des IC-Gehäuses, dar-gestellt in der Figur 5a.

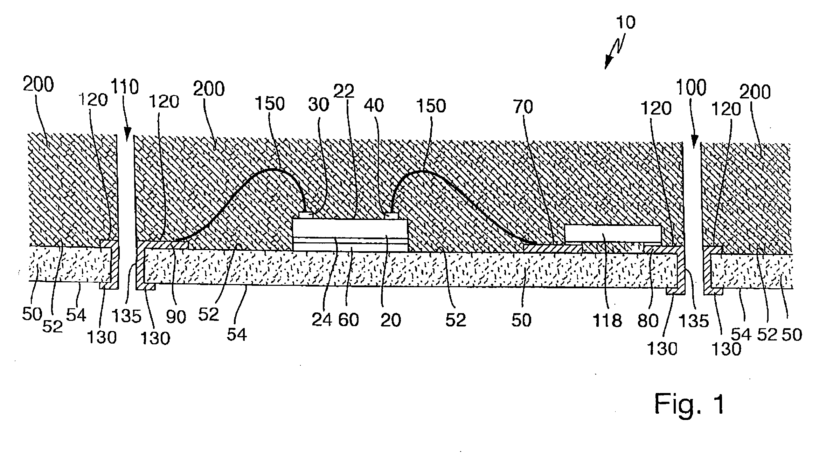

Die Abbildung der Figur 1 zeigt eine schematische Ansicht einer ersten Ausführungsform, aufweisend ein IC-Gehäuse 10 mit einem Halbleiterkörper 20 mit einer Oberseite 22 und einer Unterseite 24. Der Halbleiterkörper 20 weist eine nicht dargestellte monolithisch integrierte Schaltung mit einer ersten metallischen Kontaktfläche 30 und einer zweiten metallischen Kontaktfläche 40 auf. Die beiden Kontaktflächen 30 und 40 sind an der Oberseite 22 des Halbleiterkörpers 20 ausgebildet.

Die integrierte Schaltung ist mittels nicht dargestellten Leiterbahnen mit den beiden elektrischen Kontaktflächen 30 und 40 verschaltet. Des Weiteren ist ein Trägersubstrat 50 mit einer Oberseite 52 und einer Unterseite 54 vorgesehen. Der Halbleiterkörper 20 ist mit der Unterseite 24 auf der Oberseite 52 des Trägersubstrats 50 mittels einer Klebeverbindung 60 mit dem Trägersubstrat 50 kraftschlüssig verbunden. Vorzugsweise ist die Klebeverbindung 60 als eine doppeltseitig klebende Folie ausgebildet. Das Trägersubstrat 50 weist eine erste Metallfläche 70 und einen ersten Anschlusskontakt 80 und einen zweiten Anschlusskontakt 90 auf. Die beiden Anschlusskontakte 80 und 90 umfassen eine erste lochartig durch das Trägersubstrat 50 ausgebildete Durchkontaktierung 100 und eine zweite lochartig durch das Trägersubstrat 50 ausgebildete Durchkontaktierung 110 auf. Die beiden Durchkontaktierungen 100 und 110 weisen einen kreisförmigen Querschnitt auf und sind in einem Randbereich des Trägersubstrats 50 ausgebildet.

Ein erstes elektronisches Bauelement 118 ist mit der ersten Metallfläche 70 und mit dem ersten Anschlusskontakt 80 verschaltet. Der erste Anschlusskontakt 80 ist mit der ersten Durchkontaktierung 100 und der zweite Anschlusskontakte 90 mit der zweiten Durchkontaktierung 110 verschaltet; wobei an den Innenseiten der beiden Durchkontaktierungen 100 und 110 der jeweilige Anschlusskontakt 80 und 90 ausgebildet ist. Hierbei bilden die beiden Anschlusskontakte 80 und 90 bei beiden Durchkontaktierungen an der Oberseite 52 des Trägersubstrat 50 eine Randfläche 120 und an der Unterseite 54 des Trägersubstrat 50 eine Randfläche 130 aus. Vorzugsweise sind die beiden Randflächen 120 und 130 und die Innenseiten 135 jeweils einstückig mit dem jeweiligen Anschlusskontakt 80 und 90 ausgebildet.

Die beiden Kontaktflächen 30 und 40 sind jeweils mittels eines Bonddrahtes 150 mit dem zweiten Anschlusskontakt 90 und dem ersten Anschlusskontakt 80 verschaltet. Hierbei ist vorliegend die elektrische Kontaktfläche 40 mit der ersten Metallfläche 70 verschaltet. Das erste Bauelement 118 ist mit der ersten Metallfläche 70 und mit dem ersten Anschlusskontakt 80 verschaltet. Anders ausgedrückt bildet die zweite Kontaktfläche 40 mit dem der ersten Metallfläche 70 und dem ersten Bauelement 118 und dem ersten Anschlusskontakt 80 eine Reihenschaltung aus. An der gesamten Oberseite 52 des Trägersubstrats 50 ist eine Vergussmasse 200 ausgebildet, so dass unter anderem die Bonddrähte 150, der Halbleiterkörper 20 und das erste elektronische Bauelement 118 mit Vergussmasse 200 abgedeckt bzw. umschlossen sind. Die Unterseite 54 des Trägersubstrats 50 sowie an der Oberseite 52 des Trägersubstrats 50 die Durchkontaktierungen 100 und 110 sind frei von der Vergussmasse 200, um eine elektrische Kontaktierung mit weiteren Baugruppen zu gewährleisten. Als Baugruppen sind unter anderem Teile von Steckverbindungen umfasst. Das Trägersubstrat 50 ist plattenförmig aus einem elektrisch isolierenden Material vorzugsweise einstückig ausgebildet. Vorzugsweise weist die Platte eine Dicke unterhalb 2 mm, höchst vorzugsweise eine Dicke unterhalb 0,5 mm auf. Ferner ist es bevorzugt, dass das IC-Gehäuse 10 eine quaderförmige Form aufweist.

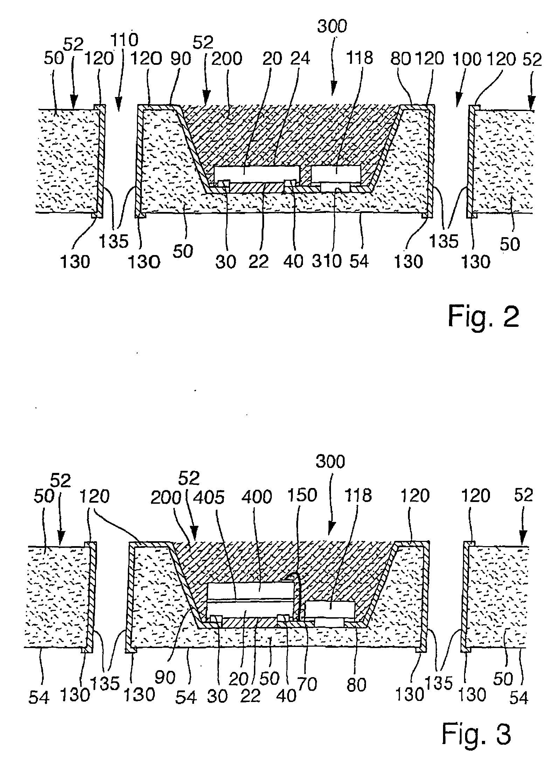

In der Figur 2 ist eine Querschnittsansicht auf eine zweite erfindungsgemäße Ausführungsform eines IC-Gehäuses 10 dargestellt. Nachfolgend werden nur die Unterschiede zu der ersten Ausführungsform, dargestellt In der Figur 1, erläutert. Das Trägersubstrat 50 weist an der Oberseite 52, vorzugsweise in der Mitte eine wannenförmige Ausformung 300 mit einem Bodenbereich 310 auf. In dem Bodenbereich 310, der insbesondere plan ausgebildet ist, sind der Halbleiterkörper 20 und das elektronische Bauteil 118 nebeneinander angeordnet. Die Oberseite 22 mit den beiden Kontaktflächen 30 und 40 des Halbleiterkörpers 20 zeigt nun in Richtung des Bodenbereichs 310. Die beiden Kontaktflächen 30 und 40 sind elektrisch mit dem zweiten Anschlusskontakt 90 und dem ersten Anschlusskontakt 80 verschaltet. Die beiden Anschlusskontakte 70 und 80 weisen Leiterbahnabschnitte auf, wobei die Leiterbahnabschnitte sich über Rand der Wanne zu dem ersten Anschlusskontakt 100 und zu dem zweiten Anschlusskontakte 110 erstrecken und jeweils mit dem zugeordneten Anschlusskontakt. 100 und 110 verschaltet. Vorliegend ist nur die Wanne mit der Vergussmasse 200 aufgefüllt, d.h. die restliche Oberseite 52 des Trägersubstrats 50 so wie die Unterseite 54 des Trägersubstrats 50 weist keine Vergussmasse auf.

In der Figur 3 ist eine Querschnittsansicht auf eine dritte erfindungsgemäße Ausführungsform eines IC-Gehäuses 10 dargestellt. Nachfolgend werden nur die Unterschiede zu der zweiten Ausführungsform, dargestellt in der Figur 2, erläutert. In der wannenförmigen Ausformung 300 mit einem Bodenbereich 310 ist auf dem ersten Halbleiterkörper 20 ein weiterer Halbleiterkörper 400 auf einer Klebeschicht 405 angeordnet, wobei der zweite Halbleiterkörper 400 mittels Bonddrähten 150 mit den Anschlusskontakten 100 und 110 verschaltet ist.

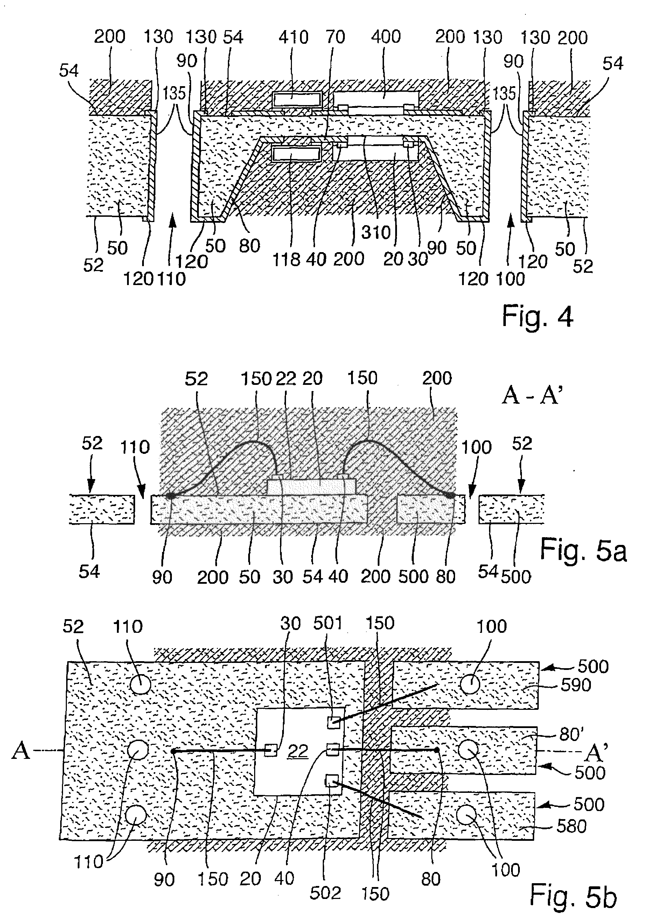

In der Figur 4 ist eine Querschnittsansicht auf eine vierte erfindungsgemäße Ausführungsform eines IC-Gehäuses 10 dargestellt. Nachfolgend werden nur die Unterschiede zu der zweiten Ausführungsform, dargestellt in der Figur 2, erläutert. Der zweite Halbleiterkörper 400 ist auf der Unterseite 54 des Trägersubstrats 50 mittels des Leitklebers angeordnet. Ferner ist an der Unterseite 54 neben dem zweiten Halbleiterkörper 400 ein zweites elektronisches Bauelement 410 angeordnet .An der Unterseite 54 ist mit Ausnahme der Durchkontaktierungen 100 und 110 das Trägersubstrat 50 mit der Vergussmasse 200 bedeckt, so dass auch die Bauelemente 400 und 410 mit Vergussmasse 200 bedeckt sind.

In der Figur 5a ist eine Querschnittsansicht entlang einer Linie A- A' auf eine fünfte erfindungsgemäße Ausführungsform eines IC-Gehäuses 10 dargestellt. Nachfolgend werden nur die Unterschiede zu der ersten Ausführungsform, dargestellt in der Figur 1, erläutert. Das Trägersubstrat 50 ist nunmehr mehrstückig und aus einem Metall ausgebildet, insbesondere ist der erste Anschlusskontakt 80 auf einem separaten Teil 500 des Trägersubstrats 50 angeordnet. An dem separaten Teil 500, das sich auch als Pin bezeichnen lässt, ist die erste Durchkontaktierung 100 ausgebildet. In dem ein Metall vorliegt, lässt sich der Bonddraht unmittelbar mit dem ersten Anschlusskontakt 80 verschalten ohne dass der erste Anschlusskontakt 80 als Seitenwand in der Durchkontaktierung 100, 110 ausgebildet ist.

Die Vergussmasse 200 auf der Oberseite 52 ist nur auf den Bereich des ersten Halbleiterkörpers 20 und der Bonddrähte 150 und ebenfalls auch an der Unterseite 54 ist ein den zentralen Bereich des Trägersubstrats 20 angeordnet.

In der Figur 5b ist eine Draufsicht auf die fünfte erfindungsgemäße Ausführungsform des IC-Gehäuses 10, dargestellt in der Figur 5a abgebildet. Nachfolgend werden nur die Unterschiede zu der Ausführungsform, dargestellt in der Figur 5a, erläutert. Auf der Oberseite 22 des Hableiterkörpers 20 sind nun insgesamt vier Kontaktflächen 30, 40, 501 und 502 und vier separate Anschlusskontakte 80, 90, 580 und 590 angeordnet, wobei alle Kontaktflächen 30, 40, 501 und 502 mittels eines zugeordneten Bonddrahtes 150 mit den einzelnen Anschlusskontakte 80, 90, 580 und 590 verschaltet sind. Der separate Teil 500 umfasst die Kontaktflächen 80, 580 und 590. Die Durchkontaktierungen 100 und 110 sind in den einzelnen Anschlussgebieten für jedes Pin vorgesehen. Eine Ausbildung von metallischen Anschlussflächen auf dem Trägersubstrat erübrigt sich.

## Patentansprüche

1. IC-Gehäuse (10) mit einem Halbleiterkörper (20), wobei der Halbleiterkörper (20) eine monolithisch integrierte Schaltung und wenigstens zwei metallische Kontaktflächen (30, 40) aufweist und die integrierte Schaltung mittels Leiterbahnen mit den beiden elektrischen Kontaktflächen (30, 40) verschaltet ist und der Halbleiterkörper (20) auf einem Trägersubstrat (50) angeordnet und mit dem Trägersubstrat (50) kraftschlüssig verbunden ist und das Trägersubstrat (50) wenigstens zwei Anschlusskontakte (80, 90) aufweist und die beiden Anschlusskontakte (80, 90) mit den beiden Kontaktflächen (30, 40) verschaltet sind und der Halbleiterkörper (20) und das Trägersubstrat (50) mit einer Vergussmasse (200) bedeckt sind, wobei die Vergussmasse (200) einen Teil des IC Gehäuses (10) ausbildet und jeweils ein Abschnitt der beiden Anschlusskontakte (80, 90) die Vergussmasse des IC Gehäuses (10) durchdringen
**dadurch gekennzeichnet, dass**
die beiden Anschlusskontakte (80, 90) auf dem Trägersubstrat (50) angeordnet sind und jeder Anschlusskontakt (80, 90) mit dem unterhalb des jeweiligen Anschlusskontakts (80, 90) liegenden Trägersubstrat (50) eine lochartige Ausformung ausbildet, wobei die jeweilige lochartige Ausformung als Durchkontaktierung (100, 110) ausgebildet ist, um eine elektrische Verbindung mit einem weiteren elektrischen Bauteil bereitzustellen.

2. IC-Gehäuse nach Anspruch 1, **dadurch gekennzeichnet, dass** das Trägersubstrat (50) ein elektrisch isolierendes Material umfasst oder aus einem elektrisch isolierenden Material besteht.

3. IC-Gehäuse (10) nach Anspruch 1 oder Anspruch 2, **dadurch gekennzeichnet, dass** die Durchkontaktierungen (100, 110) ein Aspekt Verhältnis zwischen der Länge und dem Durchmesser der Durchkontaktierung aufweisen, welches größer gleich 1 ist.

4. IC-Gehäuse (10) nach einem oder mehreren der vorangegangen Ansprüche, **dadurch gekennzeichnet, dass** die Durchkontaktierungen (100, 110) an der Lochinnenseite eine metallische Oberfläche als ein Teil des Außenkontakts (80) ausgebildet ist und einstückig mit dem Außenkontakt (80) verbunden.

5. IC-Gehäuse (10) nach einem oder mehreren der vorangegangen Ansprüche, **dadurch gekennzeichnet, dass** die Kontaktflächen (30, 40) mit einem Leitkleber oder mit einem Bonddraht (150) oder mittels einer Lötverbindung oder mittels Sintern oder mittels eines Thermokompressionsbonds mit den Anschlusskontakten (80, 90) elektrisch verschaltet sind.

6. IC-Gehäuse (10) nach einem oder mehreren der vorangegangen Ansprüche, **dadurch gekennzeichnet, dass** auf dem Trägersubstrat (50) ein weiteres von dem Halbleiterkörper (20) beabstandetes elektronisches Bauelement (120) angeordnet und mit der Vergussmasse (200) bedeckt ist.

7. IC-Gehäuse (10) nach einem oder mehreren der vorangegangen Ansprüche, **dadurch gekennzeichnet, dass** Trägersubstrat (50) als eine plane Platte ausgebildet ist.

8. IC-Gehäuse (10) nach einem oder mehreren der vorangegangen Ansprüche, **dadurch gekennzeichnet, dass** das Trägersubstrat (50) an einer Oberseite (52) eine wannenförmige Ausformung aufweist und der Halbleiterkörper (20) in dem Bodenbereich der wannenförmigen Ausformung angeordnet ist.

9. IC-Gehäuse (10) nach einem oder mehreren der vorangegangen Ansprüche, **dadurch gekennzeichnet, dass** die Durchkontaktierungen (100, 110) in einem Randbereich des Trägersubstrats (50) ausgebildet sind.

10. IC-Gehäuse (10) nach einem oder mehreren der vorangegangen Ansprüche, **dadurch gekennzeichnet, dass** die lochartige Ausformung als eine durchgehende Öffnung ausgebildet ist und die Öffnung an der Innenseite metallisch leitfähig ist.
